# EUROPÄISCHE PATENTSCHRIFT

(11) **EP 0 651 603 B1**
(45) Veröffentlichungstag und Bekanntmachung des Hinweises auf die Patenterteilung: **11.12.1996**
(21) Anmeldenummer: 94115102.9
(22) Anmeldetag: 24.09.1994
(51) Int. Cl.: H05K 7/20

(54) **Flexible Wärmeübertragungsvorrichtung**
Flexible heat transfer device
Dispositif flexible pour le transfert de chaleur

(30) Priorität: 29.10.1993 DE 4336961
(43) Veröffentlichungstag der Anmeldung: 03.05.1995
(73) Patentinhaber: KERAFOL Keramische Folien GmbH, D-92676 Eschenbach/Opf. (DE)
(72) Erfinder: Koppe, Franz, D-92676 Eschenbach/Opf. (DE)
(74) Vertreter: Hafner, Dieter, Dr.rer.nat., Dipl.-Phys.

(56) Entgegenhaltungen:
- EP-A- 0 476 164
- DE-A- 3 629 565
- DE-C- 3 911 008
- GB-A- 2 239 720
- US-A- 4 605 986
- PATENT ABSTRACTS OF JAPAN, unexamined applications, E Sektion, Band 17, Nr. 178, 7. April 1993 THE PATENT OFFICE JAPANESE GOVERNMENT Seite 112 E 1347; & JP-A-04 332 489 (MITSUBI- SHI)

## Beschreibung

Die Erfindung betrifft eine flexible Wärmeübertragungsvorrichtung zur Ableitung von Wärme aus elektrischen oder elektronischen Bauteilen oder deren Kühlkörpern oder Gehäusen. Derartige flexible Wärmeübertragungsvorrichtungen weisen einen Abschnitt einer Wärmeleitfolie aus Isolationsmaterial auf. In der Regel bestehen solche Wärmeleitfolien aus gegossenen Kunststoffmaterialien, in welche keramische oder metallische Teilchen zur positiven Beeinflussung der Wärmeleitfähigkeitseigenschaften inkorporiert sind. Solche Wärmeleitfolien werden in elektrischen oder elektronischen Geräten eingesetzt, in denen Bauteile enthalten sind, deren Wärme zum Schutz der Bauteile und benachbart liegender Bauteile gezielt abzuführen ist. Dazu werden die Gehäuse der elektronischen Bauteile oder deren Kühlkörper mit einer Wärmeleitfolie so in Verbindung gebracht, daß ein Wärmeübergang vom Bauteil in die Folie stattfinden kann. Mit einem anderen Bereich wird die Wärmeleitfolie sodann mit einem Körper in Verbindung gebracht, der die Wärme zunächst auf oder übernehmen und dann so abstrahlen kann, daß eine Überhitzungsgefährdung für das elektronische Gerät nicht gegeben ist.

Typische Eigenschaften einer bekannten Wärmeleitfolie aus ausgehärtetem Silikon mit eingeschlossenen Keramikpulverteilchen sind folgende: Die Folie ist thermisch leitend, elektrisch isolierend, temperaturbeständig bis etwa 250°C gasundurchlässig und hat eine Stärke von beispielsweise 0,2mm bis zu mehreren Millimetern.

Aus EP-A-0 476 164 ist ferner eine Isolierscheibe mit guter Wärmekopplung für zwangsgekühlte Kondensatoren bekannt, die insbesondere zwischen einem metallischen Kondensatorgehäuse und einem Kühlkörper angeordnet ist, wobei sie aus mindestens zwei an den Rändern zusammengeschweißten Folien besteht, zwischen denen eine thermisch leitfähige Masse angeordnet ist und zumindest eine der Folien eine Isolationsfolie ist.

Der Erfindung liegt die Aufgabe zugrunde, eine flexible Wärmeübertragungsvorrichtung anzugeben, deren Wärmeübertragungsqualitäten bei höherer mechanischer Belastbarkeit verbessert sind. Diese Aufgabe wird dadurch gelöst, daß sich zumindest abschnittsweise parallel zur isolierenden Wärmeleitfolie ein Abschnitt einer metallischen Folie oder einer metallischen Lage erstreckt und mit dieser einen mindestens zweilagigen flexiblen Verbundkörper bildet.

Es hat sich herausgestellt, daß sich durch eine Mehrfachschicht, bestehend aus einem Leiter und einem wärmeleitenden elektrischen Isolator, wie er durch die Wärmeleitfolie dargestellt ist, die Wärmeübergangsquotienten von elektronischen Bauteilen in die Folie hinein, durch die Folie hindurch und in Ableitkörper hinein stark verbessern lassen, Tests haben ergeben, daß durch den zumindest teilweise parallelen Verlauf von metallischer Folie und Wärmeleitfolie eine drastische Erhöhung der Wärmeübergänge erzielbar ist, insbesondere die Einleitung der Ohmschen Wärme in die Folie hinein, die aus elektronischen Bauteilen abgeführt werden muß, ist durch die Erfindung erleichtert.

Es kann vorteilhaft sein, wenn die metallische Folie oder Lage zumindest teilweise freiliegt. Dies läßt sich beispielsweise dadurch erreichen, daß man einen nur zweilagigen Verbundkörper vorsieht, mit anderen Worten auf eine Seite der Wärmeleitfolie eine metallische Folie aufklebt oder aufkaschiert, die nicht durch eine Deckschicht abgedeckt ist. Dadurch lassen sich neben thermischen Leiteigenschaften auch elektrische Leiteigenschaften der Wärmeübertragungsvorrichtung nutzen.

Besonders vorteilhaft ist es, wenn die metallische Folie oder metallische Lage im Kantenbereich der Wärmeübertragungsvorrichtung überdeckt ist. Zum einen werden innerhalb von engen elektronischen Schaltungen eine unbeabsichtigte Kontaktierung und elektrische Überschläge vermieden, zum anderen wird die Stabilität der Folie verbessert. Besonders vorteilhaft ist ein Mehrfachverbundkörper, bei welchem die metallische Folie oder metallische Lage beidseitig von nichtleitenden Folien eingeschlossen ist. Dabei kann beispielsweise auf einer Seite der metallischen Folie eine Wärmeleitfolie angebracht sein, die andere Seite der metallischen Folie wird durch eine nur isolierende Deckfolie abgedeckt. Es ist auch möglich, auf beiden Seiten der metallischen Folie Wärmeleitfolien anzubringen und diese beiden elektrisch nichtleitenden Folien am Rand miteinander zu verbinden. Dies kann dadurch geschehen, daß die beiden elektrisch nichtleitenden Folien im Randbereich parallel zusammenlaufen und dort miteinander verschweißt oder verklebt werden.

Besonders zweckdienlich kann es sein, in einer der beiden elektrisch nichtleitenden Folien austrennbare oder abnehmbare Ausschnitte vorzusehen, um kontaktierbare Ausschnitte der ansonsten eingeschlossenen metallischen Folie freizulegen.

Ansprüche 7 und 8 betreffen Klebeschichten auf der Wärmeübertragungseinrichtung, wodurch diese besonders leicht montierbar wird.

Es kann auch zweckdienlich sein, die metallische Folie mit einer weiteren metallischen Schicht aus einem unterschiedlichen Material zu überziehen. Beispielsweise kann die Metallfolie eine Kupferfolie sein, die mit einer dünnen Stahlbandbeschichtung überzogen ist. Auch Zinnschichten können als zusätzliche Metallschicht in Betracht gezogen werden.

Ein besonders guter Randabschluß der Wärmeübertragungsvorrichtung wird dadurch erreicht, daß die Randbereiche des Mehrfachverbundschichtkörpers mit einem Kunststoffisolationsmaterial umspritzt sind. Insgesamt kann die Wärmeübertragungsvorrichtung entweder aus gebrauchsfertig ausgestatteten Einzelabschnitten bestehen, hier kann in Betracht gezogen werden, die Einzelabschnitte kundenspezifisch vorzurichten, es ist aber auch möglich, die Wärmeübertragungsvorrichtung in Form von Rollenmaterial auszubilden, der Benutzer kann dann selbst benötigte Abschnitte abtrennen.

Ansprüche 14 und 15 betreffen eine Wärmeübertragungsvorrichtung mit einer Mehrzahl von parallelen nebeneinander liegend metallischen Folien oder Lagen, wobei vorgesehen sein kann, daß sich die mehreren nebeneinander liegenden metallischen Folien bereichsweise überlappen. Ansprüche 16 und 17 betreffend Anschlußmittel, um einen elektrischen Kontakt mit der innerhalb der Wärmeübertragungsvorrichtung verlaufenden metallischen Folie herstellen zu können.

Die Erfindung ist anhand von Ausführungsbeispielen näher erläutert. Diese zeigen:
- Fig .1a - e: Schnittdarstellungen von denkbaren Verbundmöglichkeiten zur Bildung von unterschiedlichen Wärmeübertragungsvorrichtungen;
- Fig. 2: eine perspektivische Darstellung einer im Seitenkantenbereich abgeschlossenen Wärmeübertragungsvorrichtung ;
- Fig. 3: eine schematisierte perspektivische Darstellung einer Möglichkeit, den Kantenbereich der Wärmeübertragungsvorrichtung zu verschließen.

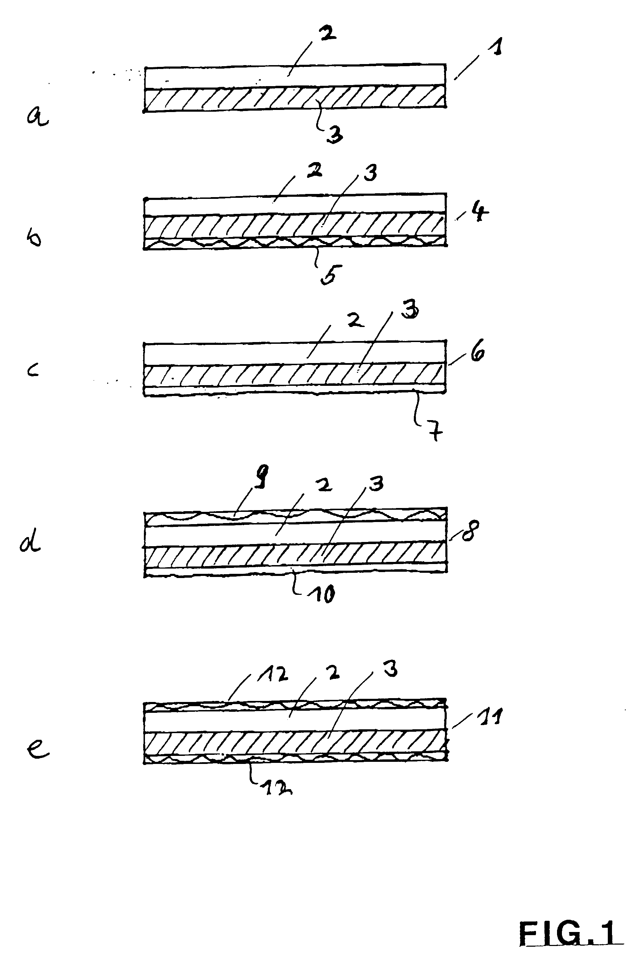

Zunächst wird auf Fig. 1 Bezug genommen. Fig. 1a zeigt eine Wärmeübertragungsvorrichtung in Form eines zweilagigen Verbundkörpers 1, bestehend aus einer Wärmeleitfolie 2 und einer Metallfolie 3, deren Stärke beispielsweise 0,01 - mehrere Millimeter betragen kann. Es ist bedeutungsvoll, daß die dargestellten Dickenverhältnisse nicht notwendigerweise richtig sind.

Fig. 1b zeigt einen dreilagigen Verbundkörper 4, bestehend aus einer Wärmeleitfolie 2, einer Metallfolie 3 und einer Klebeschicht 5.

Fig. 1c zeigt ebenfalls einen dreilagigen Verbundkörper 6, bestehend aus einer Wärmeleitfolie 2, einer Metallfolie 3 und einer zusätzlichen Metallschicht, die beispielsweise eine dünne Zinnschicht 7 sein kann.

Fig. 1d zeigt einen vierlagigen Verbundkörper 8, bei dem die Wärmeleitfolie 2 zwischen der Metallfolie 3 und einer obenliegenden Klebeschicht 9 angebracht ist. Mit 10 ist eine zusätzliche Metallschicht bezeichnet.

Fig. 1e zeigt einen vierlagigen Verbundkörper 11, bei dem die Wärmeleitfolie 2 und die Metallfolie 3 beidseitig von Klebeschichten 12 überdeckt sind.

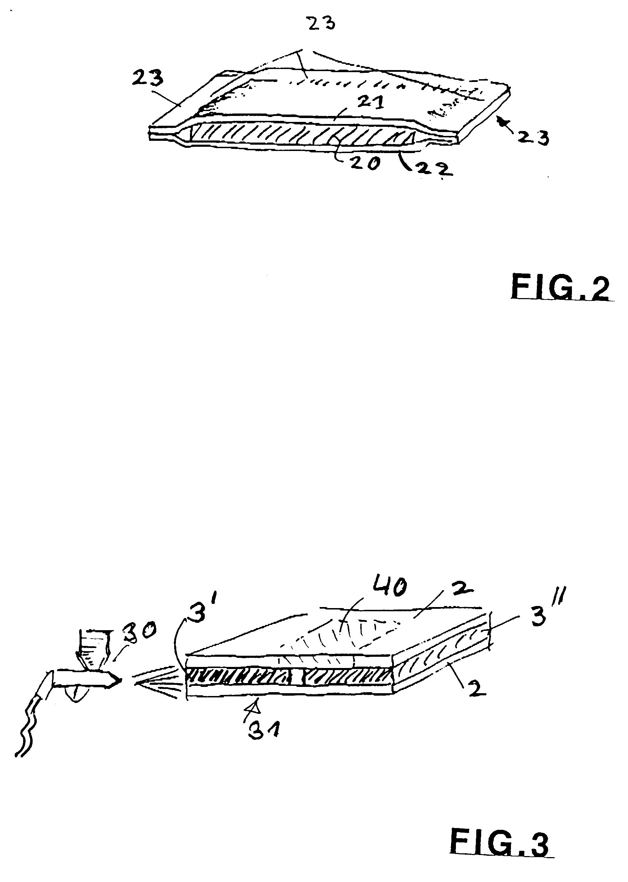

Bei dem in Fig 2. dargestellten Ausführungsbeispiel ist zu sehen, daß die metallische Folie 20 zwischen zwei Schichten 21, 22 eingelegt ist, welch letztere im Randbereich 23 parallel zusammengeführt und dort miteinander verschweißt sind. Dadurch entsteht ein Gebilde, das einer "Maultasche" angenähert ist.

Fig. 3 zeigt schematisiert einen Verbundkörper, bestehend aus Wärmeleitfolie - Metallfolie - Wärmeleitfolie. Mit 30 ist eine Spritzpistole zum Aufspritzen von Kunststoffmaterial auf die Randbereiche 31 dargestellt, das Besprühen der Randbereiche kann entweder einzeln erfolgen oder auch dadurch, daß die dreilagigen oder auch mehrlagigen Verbundkörper des Stapels aufeinandergelegt und zusammen besprüht werden.

In Fig. 3 ist noch zu sehen, daß die Wärmeleitfolie 2 einen austrennbaren Abschnitt 40 aufweist, der durch eine Perforation der Folie gebildet wird und zum Freilegen der ansonsten eingeschlossenen metallischen Folie dient.

Ferner ist in Fig. 3 dargestellt, daß innerhalb eines Verbundkörpers mehrere i.w. parallel nebeneinander liegende metallische Folien 3', 3" vorgesehen sind.

## Patentansprüche

1. Flexible Wärmeübertragungsvorrichtung zur Ableitung von Wärme aus elektrischen oder elektronischen Bauelementen oder deren Kühlkörpern oder Gehäusen in benachbart liegende Kühlkörper-, Gehäusebereiche oder Chassis von elektrischen/elektronischen Geräten, umfassend mindestens einen Abschnitt einer Wärmeleitfolie aus Isolationsmaterial,
**gekennzeichnet durch**
einen Abschnitt einer metallischen Folie (3) oder metallischen Lage, der sich zumindest abschnittsweise parallel zur Wärmeleitfolie (2) erstreckt und mit dieser einen mindestens zweilagigen flexiblen Verbundkörper (1, 4, 6, 8, 11) bildet.

2. Wärmeübertragungsvorrichtung nach Anspruch 1,
**dadurch gekennzeichnet**,
daß die metallische Folie (3) oder Lage zumindest teilweise freiliegt.

3. Wärmeübertragungsvorrichtung nach einem der vorhergehenden Ansprüche,
**dadurch gekennzeichnet**,
daß die metallische Folie (3) oder Lage im Kantenbereich (23) der Vorrichtung überdeckt ist.

4. Wärmeübertragungsvorrichtung nach einem der Ansprüche 1 und 3,
**dadurch gekennzeichnet**,
daß die metallische Folie (3) oder Lage beidseitig von elektrisch nichtleitenden Folien, insbesondere Wärmeleitfolien (2) und/oder Deckfolienabschnitten, eingeschlossen ist.

5. Wärmeübertragungseinrichtung nach Anspruch 4,
**dadurch gekennzeichnet**,
daß die beidseitig auf die metallische Folie (3) oder Lage aufgebrachten nichtleitenden Folien (2) im Randbereich (23) parallel zusammenlaufen und dort miteinander verbunden, insbesondere verschweißt oder verklebt sind.

6. Wärmeübertragungseinrichtung nach einem der vorhergehenden Ansprüche,
**dadurch gekennzeichnet**,
daß die mindestens eine der beiden elektrisch nichtleitenden Folien (2) austrennbare oder abnehmbare Abschnitte abweist, um kontaktierbare Abschnitte (40) der ansonsten eingeschlossen metallischen Folie (3) oder Lage freizulegen.

7. Wärmeübertragungseinrichtung nach einem der vorhergehenden Ansprüche,
**dadurch gekennzeichnet**,
daß die metallische Folie (3) oder die Wärmeleitfolie (2) mit einer außenliegenden Klebeschicht (5,9,12) versehen sind.

8. Wärmeübertragungseinrichtung nach einem der vorhergehenden Ansprüche,
**dadurch gekennzeichnet**,
daß sie beidseitig eine außenliegende Klebeschicht (12) aufweist.

9. Wärmeübertragungseinrichtung nach einem der vorhergehenden Ansprüche,
**dadurch gekennzeichnet**,
daß die metallische Folie (3) eine weitere metallische Schicht (7, 10) aus einem zu ihr unterschiedlichen Material trägt.

10. Wärmeübertragungseinrichtung nach einem der vorhergehenden Ansprüche,
**dadurch gekennzeichnet**,
daß ihre Randbereiche (31) mit einem Kunststoffisolationsmaterial umspritzt sind.

11. Wärmeübertragungseinrichtung nach einem der vorhergehenden Ansprüche,
**dadurch gekennzeichnet**,
daß die Randbereiche (31) gegenüber der Gesamtstärke der Vorrichtung im Mittelbereich erhaben sind.

12. Wärmeübertragungseinrichtung nach einem der vorhergehenden Ansprüche,
**dadurch gekennzeichnet**,
daß sie aus gebrauchsfertig ausgestanzten Einzelabschnitten besteht.

13. Wärmeübertragungseinrichtung nach einem der vorhergehenden Ansprüche,
**dadurch gekennzeichnet**,
daß sie als Rollenmaterial ausgebildet ist.

14. Wärmeübertragungseinrichtung nach einem der vorhergehenden Ansprüche,
**dadurch gekennzeichnet**,
daß sie mehrere im wesentlichen parallel nebeneinander liegende metallische Folien (3', 3") oder Lagen aufweist.

15. Wärmeübertragungseinrichtung nach einem der vorhergehenden Ansprüche,
**dadurch gekennzeichnet**,
daß sich die mehreren nebeneinander liegenden metallischen Folien (3', 3") oder Lagen bereichsweise überlappen.

16. Wärmeübertragungseinrichtung nach einem der vorhergehenden Ansprüche,
**dadurch gekennzeichne**t,
daß mindestens eine metallische Folie (3) an mindestens einer Stelle aus dem sie sonst umschließenden Verbund isolierender Folien insbesondere seitlich herausgeführt ist.

17. Wärmeübertragungseinrichtung nach einem der vorhergehenden Ansprüche,
**dadurch gekennzeichnet**,
daß sie mindestens ein gesondertes Anschlußelement aufweist, das mindestens eine zwischen isolierenden Schichten eingeschlossene metallische Folie (3) oder Lage kontaktiert.
